(19) Europäisches Patentamt / European Patent Office / Office européen des brevets

(11) **EP 2 160 837 B1**

(12) **FASCICULE DE BREVET EUROPEEN**

(45) Date de publication et mention
de la délivrance du brevet:
**24.07.2024   Bulletin 2024/30**

(21) Numéro de dépôt: **08806035.5**

(22) Date de dépôt: **19.06.2008**

(51) Classification Internationale des Brevets (IPC):
**H03M 7/30** (2006.01)

(52) Classification Coopérative des Brevets (CPC):
**H03M 7/30; H04N 19/12**

(86) Numéro de dépôt international:
**PCT/FR2008/051101**

(87) Numéro de publication internationale:
**WO 2009/004255 (08.01.2009 Gazette 2009/02)**

(54) **SÉLECTION DE FONCTIONS DE DÉCODAGE DISTRIBUÉE AU DÉCODEUR**

AUSWAHL VON AN DEN DECODIERER VERTEILTEN DECODIERUNGSFUNKTIONEN

SELECTION OF DECODING FUNCTIONS DISTRIBUTED TO THE DECODER

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité:  **29.06.2007   FR 0704710**

(43) Date de publication de la demande:
**10.03.2010   Bulletin 2010/10**

(73) Titulaire: **Orange**
**92130 Issy-les-Moulineaux (FR)**

(72) Inventeurs:
• **JUNG, Joël**
**78320 Le Mesnil Saint Denis (FR)**
• **LAROCHE, Guillaume**
**35700 Rennes (FR)**

(74) Mandataire: **Plasseraud IP**
**66, rue de la Chaussée d'Antin**
**75440 Paris Cedex 09 (FR)**

(56) Documents cités:
• **LAROCHE G ET AL: "A spatio-temporal competing scheme for the rate-distortion optmized selection and coding of motion vectors", PROCEEDINGS OF THE EUROPEAN SIGNAL PROCESSING CONFERENCE, XX, XX, 4 September 2006 (2006-09-04), pages 1 - 6, XP002439848**

• NAKACHI T ET AL: "A study on multiresolution lossless video coding using inter/intra frame adaptive prediction", VISUAL COMMUNICATIONS AND IMAGE PROCESSING; 8-7-2003 - 11-7-2003; LUGANO,, 8 July 2003 (2003-07-08), XP030080786
• JOEL JUNG ORANGE-FRANCE TELECOM R&D ET AL: "KTA 1.3 software manual", 32. VCEG MEETING; 80. MPEG MEETING; 23-4-2007 - 27-4-2007; SAN JOSE;(VIDEO CODING EXPERTS GROUP OF ITU-T SG.16),, no. VCEG-AF11, 19 April 2007 (2007-04-19), XP030003532, ISSN: 0000-0068
• JUNG J., LAROCHE G., PESQUET B.: "RD-optimized competition scheme for efficient motion prediction", PROCEEDINGS OF SPIE, vol. 6508, 29 January 2007 (2007-01-29), pages 1 - 11, XP002468795, Retrieved from the Internet <URL:http://spiedl.aip.org/getpdf/servlet/GetPD FServlet?filetype=pdf&id=PSISDG006508000001 650815000001&idtype=cvips&prog=normal> [retrieved on 20080211]
• CHANG S G ET AL: "A simple block-based lossless image compression scheme", SIGNALS, SYSTEMS AND COMPUTERS, 1996. CONFERENCE RECORD OF THE THIRTIETH ASILOMAR CONFERENCE ON PACIFIC GROVE, CA, USA 3-6 NOV. 1996, LOS ALAMITOS, CA, USA,IEEE COMPUT. SOC, US, 3 November 1996 (1996-11-03), pages 591 - 595, XP010231497, ISBN: 0-8186-7646-9

**Description**

La présente invention concerne les techniques de décodage d'informations par compétition.

Plusieurs procédés de codage et de décodage existent pour la transmission d'images. On distingue notamment des grands types de codage tels que le codage dit « intra » où une image est codée de manière autonome c'est-à-dire sans références à d'autres images, ou encore le codage dit « inter » qui consiste à coder une image courante par rapport à des images passées de manière à exprimer et ne transmettre que la différence entre ces images.

Quel que soit le type de codage, de nombreuses fonctions de codage et de décodage sont disponibles. Par exemple, pour un codage de type inter, les fonctions de codage sont les différentes fonctions de prédiction utilisables.

De manière classique, une fonction de codage particulière est sélectionnée par compétition entre différentes fonctions disponibles sur la base d'un critère de choix ou fonction de choix. Par exemple, un critère classique est le rapport entre la distorsion résultant du codage et le débit de manière à trouver un compromis entre la qualité et la bande passante.

Dans les environnements classiques de codage et de décodage d'images, ce choix est mis en oeuvre de manière unilatérale au niveau du codeur. Il en résulte la sélection d'une fonction de codage qui doit être transmise au décodeur à chaque changement. Des exemples et des modes de réalisation correspondant à de tels environnements de l'état de la technique peuvent être trouvés dans « RD-optimized compétition scheme for efficient motion prédiction », JUNG J., LAROCHE G., PESQUET B., PROCEEDINGS OF SPIE, [Online] vol. 6508, pages 1-11, 29 janvier 2007.

Dans de tels modes de réalisation, le décodeur a un rôle passif et ses capacités de calcul et de traitement sont sous-exploitées.

En particulier, dans les systèmes classiques, les informations descriptives de la fonction de codage utilisée sont volumineuses et consomment une part non négligeable de la bande passante. Qui plus est, la taille des informations descriptives et la fréquence des changements augmentent avec la taille de l'ensemble de fonctions de codage disponibles.

Un avantage de la présente invention est d'améliorer la situation en permettant de réaliser certains calculs et traitements au niveau du décodeur et d'optimiser l'utilisation de la bande passante.

- A cet effet, la présente invention a pour objet un procédé de décodage tel que défini dans la revendication 1.

Grâce à ce procédé, le décodeur dispose d'informations relatives à la fonction de choix, ce qui lui permet de reproduire de manière autonome les opérations de sélection réalisées au niveau du codeur. En outre, les changements de critère de sélection étant moins fréquents que les changements de fonction de codage/décodage, la quantité de données non utiles transmise est réduite.

Dans un mode de réalisation particulier, l'application de la ou desdites fonctions de choix aboutit à l'obtention d'une unique fonction respectivement de décodage.

En conséquence, le décodeur est apte à identifier de manière certaine la fonction de décodage à utiliser et il n'est pas nécessaire de transmettre d'informations descriptives correspondantes.

Dans un mode de réalisation, la ou lesdites fonctions de choix aboutissent à l'obtention d'un groupe de plusieurs fonctions de décodage valides et le procédé comporte en outre :

- une réception d'un identifiant d'une fonction de décodage ; et
- une sélection d'une fonction de décodage résultant de l'application dudit identifiant audit groupe de fonctions de décodage valides.

Ainsi, il est possible de transmettre un identifiant d'une taille réduite car exprimé par rapport à un groupe d'une taille inférieure à l'ensemble des fonctions existantes.

Dans encore un autre mode de réalisation, la ou les fonctions de choix sont sélectionnées dans un ensemble indexé de fonctions de choix, les fonctions de choix étant fondées sur des critères respectifs distincts, et lesdites informations descriptives correspondantes sont exprimées par rapport audit ensemble indexé. Ceci permet une transmission simple et efficace des informations descriptives des fonctions de choix.

Avantageusement, le procédé comprend une phase préalable de communication entre un codeur et un décodeur pour déterminer ledit ensemble indexé de fonctions de choix. Ceci permet d'adapter et de faire évoluer la liste des fonctions de choix.

Dans un autre mode de réalisation, au moins une desdites fonctions de choix est paramétrable et lesdites informations descriptives comportent des informations de paramétrage. Ainsi, une même fonction de choix peut être paramétrée de différentes manières comme autant de fonctions différentes.

En outre, l'invention a également pour objet un programme et un dispositif correspondant.

D'autres particularités et avantages de la présente invention apparaîtront dans la description faite ci-après à titre non limitatif et en référence aux dessins annexés dans lesquels les aspects relatifs au codage ne relèvent pas de l'invention et ne sont présents qu'à titre illustratif, et dans lesquels :

- La figure 1 est un schéma montrant deux stations en communication pourvues respectivement d'un codeur et d'un décodeur vidéo ;
- Les figures 2 et 3 sont des organigrammes de procédés de codage et de décodage selon un premier mode de réalisation de l'invention ; et
- Les figures 4 et 5 sont des organigrammes de procédés de codage et de décodage selon un second mode de réalisation de l'invention.

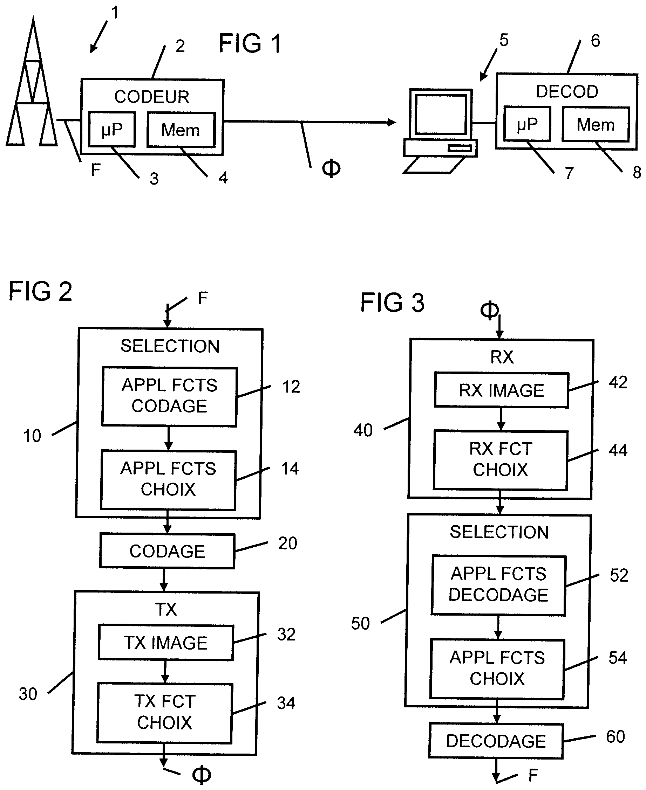

L'invention est applicable à tout système de codage et de décodage d'images, tel que, par exemple, le système représenté en référence à la figure 1. Ce système permet le codage d'une séquence vidéo d'un flux de télévision numérique F et sa transmission entre un émetteur 1 contenant un codeur vidéo 2 comportant un contrôleur ou calculateur 3 associé à une mémoire 4. La transmission est assurée vers une station de réception 5 contenant un décodeur 6 comportant également un contrôleur ou calculateur 7 et une mémoire 8.

Par exemple, l'émetteur 1 comporte une antenne émettant sur un canal hertzien de télévision numérique un flux de données Φ selon un format tel que le format dit DVB et la station 5 est un ordinateur personnel.

En référence à la figure 2, on va maintenant décrire un codage.

Le codeur 2 reçoit le flux F de données d'images d'une séquence vidéo. Ce flux est traité afin de coder chaque image ou portion d'image. Le terme image désigne généralement un élément de la séquence vidéo. En fonction des standards utilisés, le terme image peut indifféremment être remplacé par le terme trame et le terme portion par le terme bloc.

Le procédé comporte tout d'abord une sélection 10 d'une fonction de codage dans un ensemble fini de fonctions de codage, par compétition à l'aide d'une ou plusieurs fonctions de choix.

Dans le mode de réalisation décrit, la sélection comprend une application 12 de chaque fonction de codage disponible à la portion d'image courante.

La sélection 10 comporte ensuite une application 14 de la ou des fonctions de choix.

Dans ce mode de réalisation, cette ou ces fonctions de choix sont discriminantes au sens où elles aboutissent à un résultat unique.

Par exemple, les fonctions de codage sont regroupées par type ou mode, tel que les modes de codage intra, inter ou autres et une fonction de codage candidate est choisie pour chaque mode. Ainsi, les fonctions de codage de chaque mode sont d'abord comparées entre elles à l'aide de fonctions de choix spécifiques à chaque mode pour déterminer une fonction de codage candidate par mode.

La sélection 10 comporte ensuite un choix d'une fonction de codage parmi les fonctions de codage candidates. Ce choix est réalisé par l'application d'une fonction de choix adaptée pour permettre la comparaison de fonctions de codage issues de modes différents.

Bien entendu, la profondeur de choix mise en oeuvre lors de l'étape de sélection peut être plus ou moins importante. Notamment, des niveaux de choix supplémentaires peuvent être mis en oeuvre pour les critères suivants :

- le choix de l'image de référence dans le mode inter ;
- le choix de l'ordre dans lequel les coefficients d'image sont parcourus (par ligne, par colonne, en zig-zag...) ;
- le choix de la précision pixellique pour l'estimation de mouvements ;
- le choix du vecteur de mouvements ;
- le choix du prédicteur de vecteur de mouvements dans un mode de codage inter ;
- le choix de la transformée ;
- ou autres.

En outre, l'application 14 de fonctions de choix est reproductible au niveau du codeur, c'est-à-dire que les fonctions de choix sont mises en oeuvre à partir de données d'images déjà décodées. Ces données sont des données dont le codeur sait qu'elles ont déjà été décodées au niveau du décodeur.

Par exemple, un critère classique de choix tel que le rapport distorsion / débit calculé sur la base de la distorsion subie par l'image courante n'est pas utilisable par ces fonctions de choix car l'image courante ne fait pas partie des données déjà décodées.

Ainsi, la sélection 10 est similaire, en principe, à une sélection par compétition classique mais utilise des critères de choix spécifiques.

Il est toutefois possible d'utiliser des critères similaires aux critères classiques tel que le rapport débit / distorsion en considérant la distorsion de pixels de référence extérieurs à l'image à coder et appartenant à des données déjà décodées.

De nombreuses fonctions de choix à base de statistiques ou de caractéristiques des données déjà décodées peuvent être utilisées comme indiqué plus loin.

Le procédé comporte ensuite un codage 20 de la portion d'image courante à l'aide de la fonction de codage sélectionnée. Dans le mode de réalisation décrit, la sélection 10 comprenant l'application tour à tour de chaque fonction de codage, cette étape 20 correspond uniquement à l'extraction des résultats de l'application de la fonction de codage sélectionnée. Dans les modes de réalisation où les résultats de l'application des fonctions de codage ne sont pas disponibles, cette étape de codage correspond à l'application directe de la fonction de codage sélectionnée.

Ultérieurement, le procédé comporte une transmission 30 d'informations vers le décodeur 6. Cette transmission 30 comporte d'une part une transmission 32 de la portion d'images courantes sous sa forme codée et d'autre part une transmission 34 d'informations descriptives de la ou des fonctions de choix utilisées.

Les informations descriptives peuvent être de différente nature. Notamment, ces informations peuvent comporter une description explicite des fonctions de choix. Dans le mode de réalisation décrit, les fonctions de choix sont listées au niveau du codeur et du décodeur et sont indexées de manière commune. La transmission d'informations descriptives de la fonction de choix utilisée est alors la simple transmission de l'identifiant de la fonction de choix exprimé par rapport à cet index commun au codeur et au décodeur.

Au niveau du codeur, la transmission 30 correspond à l'insertion des données dans un flux de sortie.

Par exemple, la table n° 1 suivante représente un index de différentes fonctions de choix pour un prédicteur dans le cas d'un codage par compétition de vecteurs de mouvements en mode inter.

| Indice | Fonctions de choix |
|---|---|
| 0 | Propriétaire : le codeur utilise une fonction de choix qui n'appartient pas à la liste des fonctions normalisées par le décodeur |
| 1 | Fonction de choix fondée sur le coût calculé tel que dans la norme H.264 |
| 2 | Fonction de choix fondée sur le coût simplifié pour un mode temps réel |
| 3 | Fonction de choix fondée sur le coût réel (RD optimisation complète) |
| 4 | Fonction de choix fondée sur un critère statistique |
| 5 | Fonction de choix fondée sur un critère local |
| ... | ... |

Dans cette table, le choix 0 indique que le codeur ne souhaite pas informer le décodeur de la fonction de choix utilisée. Un identifiant de la fonction de codage exprimé par rapport à l'ensemble des fonctions existantes est transmit. Ce mode correspond au mode de fonctionnement classique d'un système codeur et décodeur. Ainsi la liste des fonctions de choix qui est commune au codeur et au décodeur comprend la possibilité de fonctionner de manière classique, c'est-à-dire de faire appel à une fonction de choix qui n'est connue que par le codeur et dont le résultat doit être transmis.

Les indices 1, 2 et 3 correspondent à des fonctions de choix qui sont des variations du critère débit-distorsion plus ou moins complexe selon les contraintes d'implémentation.

Les indices 4 et 5 correspondent à des fonctions de choix qui permettent respectivement que la fonction de codage soit sélectionnée en fonction de critères statistiques ou encore de critères locaux. Par exemple, la sélection porte sur une fonction de codage qui est statistiquement très fréquente ou sur une fonction de codage beaucoup utilisée au niveau local, c'est-à-dire fréquemment utilisée pour les macroblocs voisins déjà codés.

En référence à la table 2 ci-dessous, on représente différentes fonctions de choix possibles dans le cas d'un codage intra.

| Indice | Fonctions de choix |
|---|---|
| 0 | Propriétaire : le codeur utilise une fonction de choix qui n'appartient pas à la liste des fonctions normalisées par le décodeur |
| 1 | Fonction de choix fondée sur un critère statistique + RD |
| 2 | Fonction de choix fondée sur un critère de voisinage |
| 3 | Fonction de choix fondée sur un critère directionnel |
| ... | ... |

Comme indiqué précédemment, les fonctions de codage de type intra correspondent à des prédictions utilisant uniquement les redondances spatiales des images. Selon le standard H.264, il existe pour un macrobloc codé en intra 184 possibilités de codage.

Dans cette table, le choix 0 correspond, comme précédemment à un fonctionnement de type classique.

Dans le cas de l'indice 1 ou 2, le codeur choisit une fonction de codage pour le macrobloc courant en fonction des choix qui ont été faits pour les macroblocs déjà codés.

Plus précisément, la fonction de choix n°1 aboutit à une sélection de fonctions de codage selon des statistiques de sélection des différents modes puis, une sélection de la fonction de codage optimale selon un critère de débit distorsion.

La fonction de choix n°2 signifie que si les blocs voisins sont tous codés selon la même fonction de codage, cette fonction de codage est automatiquement sélectionnée. Bien sûr, il est possible de segmenter les blocs voisins en sous-groupes et d'associer une fonction de choix par sous-groupe.

La fonction de choix n°3 résulte en un choix d'une fonction de codage selon la direction favorite des gradients directionnels des blocs voisins.

Le fait de transmettre au décodeur les informations nécessaires pour réaliser le choix permet de s'assurer que le décodeur sera capable de retrouver la fonction de décodage correspondant à la fonction de codage utilisée sans qu'il soit nécessaire d'envoyer d'informations descriptives de la fonction de codage utilisée. Ceci permet d'optimiser très sensiblement l'utilisation de la bande passante en supprimant les informations descriptives de la fonction de codage utilisée.

En effet, les fonctions de choix sont utilisées plus longtemps que les fonctions de codage de sorte que la bande passante utile globale est augmentée par la transmission d'informations relatives aux fonctions de choix par comparaison à la transmission d'informations relatives aux fonctions de codage.

En référence à la figure 3, on va maintenant décrire un procédé de décodage selon un mode de réalisation de l'invention, correspondant au procédé de codage décrit précédemment.

Ce procédé débute par une étape 40 de réception comprenant une réception 42 de la portion d'image courante codée ainsi qu'une réception 44 des informations descriptives de la fonction ou des fonctions de choix utilisées.

L'étape 40 est suivie d'une étape 50 de sélection d'une fonction de décodage parmi un ensemble fini de fonctions de décodage correspondant à l'ensemble fini de fonctions de codage utilisées lors de l'étape de sélection 10.

Dans le mode de réalisation décrit, cette étape de sélection commence par une application 52 de chaque fonction de décodage disponible puis, comporte une application 54 de la ou des fonctions de choix identifiées pour sélectionner une fonction de décodage.

Dans le mode de réalisation décrit, cette application comprend un choix d'une fonction candidate par mode puis le choix d'une fonction parmi lesdites fonctions candidates de manière correspondant au choix 14 décrit en référence à la figure 2.

Les fonctions de choix étant discriminantes et applicables au niveau du décodeur, c'est-à-dire utilisant uniquement des données décodées, cette application 54 aboutit à une unique fonction de décodage correspondante à la fonction de codage utilisée lors de l'étape 20.

Enfin, le procédé de décodage comporte une étape 60 de décodage par l'application de la fonction de décodage sélectionnée.

Dans le mode de réalisation décrit, cette étape correspond à l'extraction des résultats de la fonction de décodage sélectionnée par rapport à l'ensemble des résultats mémorisés lors de l'application 52.

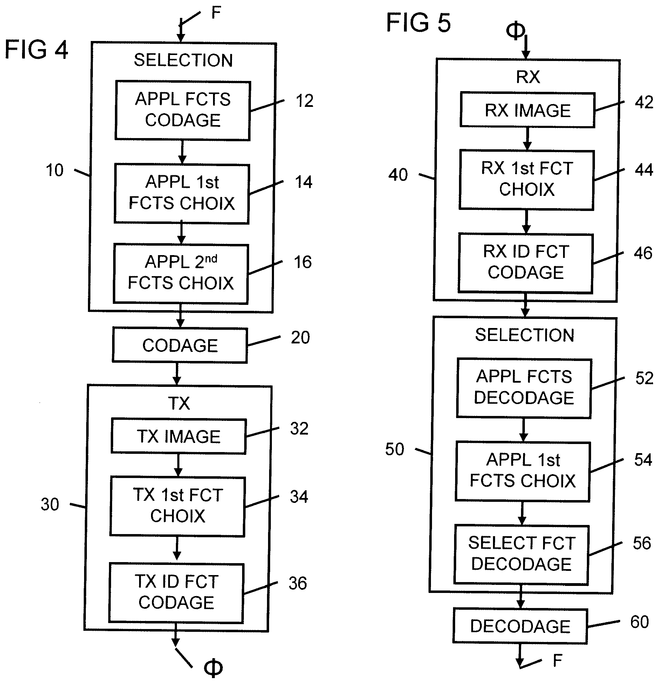

En référence aux figures 4 et 5, on va maintenant décrire un autre procédé de codage et un autre procédé de décodage, le procédé de décodage formant un autre mode de réalisation de l'invention. Sur ces figures, les étapes identiques au précédent mode de réalisation portent les mêmes numéros.

Le codage représenté en référence à la figure 4 débute de la même manière que précédemment.

Toutefois, dans ce mode de réalisation, l'application 14 des fonctions de choix, dites premières fonctions de choix, n'est pas discriminante, c'est-à-dire que ces fonctions n'aboutissent pas à l'identification d'une unique fonction de codage mais d'un groupe de fonctions de codage, dit groupe de fonctions de codage valides. Les fonctions de choix mises en oeuvre dans le premier mode de réalisation sont des fonctions de ce type.

Un deuxième type de fonctions de choix est alors mis en oeuvre lors d'un choix 16 pour aboutir à une unique fonction de codage sélectionnée dans le groupe des fonctions de codage valides. Les fonctions de choix du second type utilisent indifféremment des données déjà décodées ou pas. En effet, les fonctions de choix de ce type sont appliquées uniquement au niveau du codeur et seul le résultat est transmis au décodeur.

Dans ce mode de réalisation, la transmission 30 comprend une transmission 36 d'un identifiant de ladite unique fonction de codage effectivement utilisée. Cet identifiant est exprimé par rapport au groupe de fonctions de codage valides.

En effet, l'application des premières fonctions de choix aboutit à un ensemble indexé de fonctions de codage. L'application des secondes fonctions de choix permet de sélectionner une fonction de codage dans cet ensemble.

L'application des premières fonctions de choix étant reproductible au niveau du décodeur, l'identifiant de la fonction de codage sélectionné peut être exprimé par rapport au groupe de fonctions de codage valides.

Cet identifiant étant exprimé par rapport à un groupe de fonction réduit par rapport à l'ensemble des fonctions disponibles, il est de taille réduite par rapport à un identifiant classique de sorte qu'une économie de bande passante est réalisée.

Dans le mode de réalisation décrit, cet identifiant est le numéro de la fonction exprimé par rapport à un index du groupe de fonction de codage valides.

Par exemple, le codeur et le décodeur utilisent des fonctions de codage et de décodage sur des fenêtres dont la taille varie de 64 à 2 par tranche de multiples de 2. L'ensemble des fonctions valides s'exprime alors de manière simplifiée sous la forme d'un tableau tel que le tableau 3 suivant :

| Indice | Fonction de codage/décodage |
|---|---|
| 0 | Codage/ Décodage avec fenêtre de taille 2 |
| 1 | Codage/ Décodage avec fenêtre de taille 4 |
| 2 | Codage/ Décodage avec fenêtre de taille 8 |
| 3 | Codage/ Décodage avec fenêtre de taille 16 |
| 4 | Codage/ Décodage avec fenêtre de taille 32 |
| 5 | Codage/ Décodage avec fenêtre de taille 64 |

Une première fonction de choix impose une résolution d'image donnée ou supérieure à une valeur. Par exemple, cette première fonction de choix impose une taille de fenêtre supérieure à 4 de sorte que les fonctions de codage/décodage d'indices 0 et 1 correspondant à des partitions de taille 2 et 4 sont tout simplement interdites.

Le groupe des fonctions de codage/décodage valides serait alors le groupe représenté par le tableau 4 suivant :

| Indice | Fonction de codage/décodage |
|---|---|
| 0 | Codage/ Décodage avec fenêtre de taille 8 |
| 1 | Codage/ Décodage avec fenêtre de taille 16 |
| 2 | Codage/ Décodage avec fenêtre de taille 32 |
| 3 | Codage/ Décodage avec fenêtre de taille 64 |

Une autre première fonction de choix impose une suppression des petites partitions en fonction d'un critère d'homogénéité de la zone traitée. En conséquence, le groupe des fonctions de codage/décodage valides correspond au tableau 5 suivant :

| Indice | Fonction de codage/décodage |
|---|---|
| 0 | Codage/ Décodage avec fenêtre de taille 16 |
| 1 | Codage/ Décodage avec fenêtre de taille 32 |
| 2 | Codage/ Décodage avec fenêtre de taille 64 |

Le second choix 16 permet de sélectionner une fonction de codage parmi les trois fonctions de codage formant le groupe de fonction valides. L'identifiant de la fonction sélectionnée est exprimé par rapport à ce groupe et à l'index réduit correspondant.

Au niveau du procédé de décodage représenté en référence à la figure 5, la réception 40 comporte, outre la réception 42 de l'image codée et la réception 44 des informations descriptives des fonctions de choix, une réception 46 de l'identifiant de la fonction de codage utilisée.

Par ailleurs, lors de la sélection 50, l'application 52 des fonctions de choix permet uniquement d'obtenir le groupe des fonctions de décodage valides correspondant au groupe des fonctions de codage valides tel qu'obtenu à l'issue du choix 14.

Le procédé comprend ensuite une sélection 56 de la fonction de codage réalisée à l'aide de l'identifiant reçu lors de l'étape 46.

A l'issue de cette sélection 56, la fonction de décodage est identifiée et est appliquée lors de l'étape 60.

Ainsi, grâce à l'invention, le choix de la fonction de codage effectué au niveau du codeur peut être reproduit au niveau du décodeur. Avantageusement, ceci permet de réduire sensiblement la bande passante allouée à l'information d'identification de la fonction de codage en l'exprimant par rapport à un groupe de taille réduite ou en la supprimant totalement.

Bien entendu, d'autres modes de réalisation peuvent être envisagés.

Dans chacun de ces cas, des paramètres supplémentaires peuvent accompagner les fonctions de choix. Par exemple, un deuxième paramètre de choix peut signaler que la distorsion est calculée avec une somme des différences absolues (Sum of Absolute Différence - SAD) dans le domaine spatial ou une sommes différences absolues transformées (Sum of Absolute Transformed Différence - SATD) dans le domaine fréquentiel. De même, l'évaluation du débit peut tenir compte du coût en bande passante de l'image codée, du coût en bande passante de l'identifiant ou autre.

Par exemple, les fonctions de choix peuvent également être paramétrables et des informations descriptives des paramètres utilisés peuvent être transmises du codeur vers le décodeur.

Un exemple de paramètre est le nombre d'images de référence dans un codage inter en fonction d'un critère d'activité temporelle sur un nombre donné d'images précédant l'image courante.

Un autre exemple est la précision de fonction de compensations de mouvement dite "sub-pixellique".

Dans encore un autre exemple, la fonction de choix à appliquer est fondée sur la minimisation du critère débit-distorsion. Le débit est souvent considéré comme la somme des débits de toutes les composantes du flux binaire selon l'équation suivante :

$$R = R_r + \lambda_m R_m + \lambda_o R_o + \lambda_{mv} R_{mv}$$

Dans cette équation, $R_r$ est le débit du résiduel de bloc avec les composantes de luminance et de chrominance, $R_m$ est le débit du mode de codage, $R_{mv}$ le débit du résiduel de vecteur mouvement et $R_0$, le débit des autres composantes comprenant l'en-tête, la structure de bloc, les bits de bourrage et les autres quantificateurs.

Les coefficients $\lambda$ sont des coefficients de pondération dépendant du pas de quantification. Cependant, les valeurs de ces coefficients $\lambda$ sont adaptées en fonction du contenu de la séquence vidéo afin d'améliorer l'efficacité du codage.

Les informations descriptives de la fonction de choix utilisée comprennent, dans un tel mode de réalisation, des modifications des coefficients $\lambda$ à partir de critères dépendant du signal d'entrée F du codeur.

Par exemple, la table suivante traduit l'envoi de modifications des coefficients $\lambda$.

| Indices | Fonctions de choix |
|---|---|
| 0 | Propriétaire |
| 1 | Critère RD avec lambda classiques |
| ... | Critère statistique |
| 4 | Critère avec lambda mouvement augmenté (le facteur d'augmentation étant normalisé) |
| 5 | Critère avec lambda mouvement = f(caractéristiques) où caractéristiques sont des caractéristiques calculables au décodeur (quantité de mouvement global, présence de blocs skippés, etc) |

Par ailleurs, l'utilisation de l'une ou l'autre des fonctions de choix peut être déclenchée par des paramètres environnementaux comme l'évolution du débit et de la bande passante disponible ou encore par des paramètres liés aux équipements utilisés. Ainsi, dans un équipement mobile, le niveau d'une batterie peut déclencher l'utilisation de certaines fonctions de choix.

Dans un mode de réalisation particulier, le codeur et le décodeur échangent au cours d'une phase préalable la liste des fonctions de choix. Ainsi, chacun dispose de la même liste ce qui permet d'exprimer simplement l'identifiant de la fonction de choix utilisée. Un tel mode de réalisation requiert une liaison bidirectionnelle entre le codeur et le décodeur.

Au niveau du décodeur, l'implémentation de l'invention peut reposer sur des programmes adaptés pour inclure les particularités décrites précédemment. Bien entendu, il est également possible d'utiliser des processeurs spécialisés ou des circuits spécifiques.

En particulier, il est possible d'utiliser des programmes exécutés par des processeurs ou des calculateurs pour des appareils de traitement vidéo afin de mettre en oeuvre le décodage décrit précédemment. Notamment, les calculateurs 3 et 7 communiquent respectivement avec les mémoires 4 et 8 pour mettre en oeuvre les différentes étapes des procédés de décodage selon les différents modes de réalisation possibles de l'invention.

En outre, il est possible de mettre en oeuvre l'invention dans des décodeurs correspondants. Ces équipements comportent des moyens permettant de réaliser les fonctions identifiées précédemment. Ces moyens comprennent notamment des microprocesseurs, microcontrôleurs ou autres calculateurs, raccordés à des mémoires et d'autres composants.

## Revendications

1. Procédé de décodage d'au moins une portion d'image courante, le procédé étant mis en oeuvre par un dispositif de décodage, le procédé comportant :

   - une réception (42) d'une portion d'image courante codée ;
   - un décodage (60) de la portion d'image courante à l'aide d'une fonction de décodage sélectionnée ;

   le procédé étant **caractérisé en ce qu'**il comporte :

   - une réception (44) d'informations descriptives d'au moins une fonction de choix utilisée; et
   - une sélection (50) de la fonction de décodage dans un ensemble fini de fonctions de décodage à l'aide de ladite au moins une fonction de choix, ladite au moins une fonction de choix utilisant des données déjà décodées par ledit dispositif de décodage.

2. Procédé selon la revendication 1, dans lequel l'application de ladite au moins une fonction de choix aboutit à l'obtention d'une unique fonction de décodage.

3. Procédé selon la revendication 1, dans lequel l'application de ladite au moins une fonction de choix aboutit à l'obtention d'un groupe de plusieurs fonctions de décodage valides et dans lequel le procédé comporte en outre :

   - une réception (46) d'un identifiant d'une fonction de décodage ; et
   - une sélection (56) d'une fonction de décodage résultant de l'application dudit identifiant audit groupe de fonctions de décodage valides.

4. Procédé selon la revendication 1, dans lequel ladite au moins une fonction de choix est sélectionnée dans un ensemble indexé de fonctions de choix, les fonctions de choix de l'ensemble étant fondées sur des critères respectifs distincts, et lesdites informations descriptives sont exprimées par rapport audit ensemble indexé.

5. Procédé selon la revendication 4, comprenant une phase préalable de communication entre un codeur et un décodeur pour déterminer ledit ensemble indexé de fonctions de choix.

6. Procédé selon la revendication 1, **caractérisé en ce qu'**au moins une desdites fonctions de choix est paramétrable et **en ce que** lesdites informations descriptives comportent des informations de paramétrage.

7. Programme d'ordinateur pour appareil de traitement vidéo (6) comprenant des instructions pour mettre en oeuvre les étapes d'un procédé de décodage vidéo selon l'une quelconque des revendications 1 à 6 lors d'une exécution du programme par une unité de calcul (7) dudit appareil.

8. Dispositif (6) de décodage d'au moins une portion d'image courante, le dispositif comportant:

   - des moyens de réception d'une portion d'image courante codée ;
   - des moyens de décodage de la portion d'image courante à l'aide d'une fonction de décodage sélectionnée,

   le dispositif étant **caractérisé en ce qu'**il comporte :

   - des moyens de réception d'informations descriptives d'au moins une fonction de choix utilisée;
   - des moyens de sélection de la fonction de décodage dans un ensemble fini de fonctions de décodage à l'aide de ladite au moins une fonction de choix; et
   - ladite au moins une fonction de choix utilisant des données ayant déjà été décodées par le dispositif de décodage.

**Patentansprüche**

1.  Verfahren zur Decodierung mindestens eines aktuellen Bildabschnitts, wobei das Verfahren von einer Decodiervorrichtung durchgeführt wird, wobei das Verfahren aufweist:

    - einen Empfang (42) eines codierten aktuellen Bildabschnitts;
    - eine Decodierung (60) des aktuellen Bildabschnitts mit Hilfe einer ausgewählten Decodierfunktion;

    wobei das Verfahren **dadurch gekennzeichnet ist, dass** es aufweist:

    - einen Empfang (44) beschreibender Informationen mindestens einer verwendeten Wählfunktion; und
    - eine Auswahl (50) der Decodierfunktion in einer endlichen Menge von Decodierfunktionen mit Hilfe der mindestens einen Wählfunktion, wobei die mindestens eine Wählfunktion bereits von der Decodiervorrichtung decodierte Daten verwendet.

2.  Verfahren nach Anspruch 1, wobei die Anwendung der mindestens einen Wählfunktion zum Erhalt einer einzigen Decodierfunktion führt.

3.  Verfahren nach Anspruch 1, wobei die Anwendung der mindestens einen Wählfunktion zum Erhalt einer Gruppe von mehreren gültigen Decodierfunktionen führt, und wobei das Verfahren außerdem aufweist:

    - einen Empfang (46) einer Kennung einer Decodierfunktion; und
    - eine Auswahl (56) einer aus der Anwendung der Kennung an die Gruppe gültiger Decodierfunktionen resultierenden Decodierfunktion.

4.  Verfahren nach Anspruch 1, wobei die mindestens eine Wählfunktion aus einer indexierten Einheit von Wählfunktionen ausgewählt wird, wobei die Wählfunktionen der Einheit auf jeweiligen unterschiedlichen Kriterien gründen, und die beschreibenden Informationen bezüglich der indexierten Einheit ausgedrückt werden.

5.  Verfahren nach Anspruch 4, das eine vorhergehende Phase der Kommunikation zwischen einem Codierer und einem Decodierer enthält, um die indexierte Einheit von Wählfunktionen zu bestimmen.

6.  Verfahren nach Anspruch 1, **dadurch gekennzeichnet, dass** mindestens eine der Wählfunktionen parametrierbar ist, und dass die beschreibenden Informationen Parametrierungsinformationen aufweisen.

7.  Computerprogramm für ein Videoverarbeitungsgerät (6), das Anweisungen zur Durchführung der Schritte eines Videodecodierverfahrens nach einem der Ansprüche 1 bis 6 bei einer Ausführung des Programms durch eine Recheneinheit (7) des Geräts enthält.

8.  Decodiervorrichtung (6) mindestens eines aktuellen Bildabschnitts, wobei die Vorrichtung aufweist:

    - Empfangseinrichtungen eines codierten aktuellen Bildabschnitts;
    - Decodiereinrichtungen des aktuellen Bildabschnitts mit Hilfe einer ausgewählten Decodierfunktion,

    wobei die Vorrichtung **dadurch gekennzeichnet ist, dass** sie aufweist:

    - Empfangseinrichtungen von beschreibenden Informationen mindestens einer verwendeten Wählfunktion;
    - Auswahleinrichtungen der Decodierfunktion aus einer endlichen Einheit von Decodierfunktionen mit Hilfe der mindestens einen Wählfunktion; und
    - die mindestens eine Wählfunktion, die Daten verwendet, die bereits von der Decodiervorrichtung decodiert wurden.

**Claims**

1.  Method for decoding at least one current image segment, the method being implemented by a decoding device, the method comprising:

- receiving (42) a coded current image segment; and
- decoding (60) the current image segment using a selected decoding function;

the method being **characterized in that**

- descriptive information describing at least one choice function used is received (44); and
- the decoding function is selected (50) from a finite set of decoding functions using said at least one choice function, said at least one choice function using data already decoded by said decoding device.

2. Method according to Claim 1, wherein application of said at least one choice function leads to a single decoding function being obtained.

3. Method according to Claim 1, wherein application of said at least one choice function leads to a group of a plurality of valid decoding functions being obtained, and wherein the method further comprises:

- receiving (46) an identifier of a decoding function; and
- selecting (56) a decoding function resulting from application of said identifier to said group of valid decoding functions.

4. Method according to Claim 1, wherein said at least one choice function is selected from an index set of choice functions, the choice functions of the set being based on distinct respective criteria, and said descriptive information is expressed with respect to said index set.

5. Method according to Claim 4, comprising a prior phase of communication between a coder and a decoder with a view to determining said index set of choice functions.

6. Method according to Claim 1, **characterized in that** at least one of said choice functions is parameterizable and **in that** said descriptive information comprises parameterization information.

7. Computer program for an apparatus (6) for processing video, said program comprising instructions for implementing the steps of a video-decoding method according to any one of Claims 1 to 6 on execution of the program by a computing unit (7) of said apparatus.

8. Device (6) for decoding at least one current image segment, the device comprising:

- means for receiving a coded current image segment; and
- means for decoding the current image segment using a selected decoding function;

the device being **characterized in that** it comprises:

- means for receiving descriptive information describing at least one choice function used;
- means for selecting the decoding function from a finite set of decoding functions using said at least one choice function; and
- said at least one choice function using data having already been decoded by the decoding device.

## FIG 1

## FIG 2

## FIG 3

**FIG 4**

F →

SELECTION — 10

APPL FCTS CODAGE — 12

↓

APPL 1st FCTS CHOIX — 14

↓

APPL 2nd FCTS CHOIX — 16

↓

CODAGE — 20

↓

TX — 30

TX IMAGE — 32

↓

TX 1st FCT CHOIX — 34

↓

TX ID FCT CODAGE — 36

↓ Φ

**FIG 5**

Φ →

RX — 40

RX IMAGE — 42

↓

RX 1st FCT CHOIX — 44

↓

RX ID FCT CODAGE — 46

↓

SELECTION — 50

APPL FCTS DECODAGE — 52

↓

APPL 1st FCTS CHOIX — 54

↓

SELECT FCT DECODAGE — 56

↓

DECODAGE — 60

↓ F

12

**RÉFÉRENCES CITÉES DANS LA DESCRIPTION**

**Littérature non-brevet citée dans la description**

- **JUNG J. ; LAROCHE G. ; PESQUET B.** RD-optimized compétition scheme for efficient motion prédiction. *PROCEEDINGS OF SPIE,* 29 Janvier 2007, vol. 6508, 1-11